# EUROPÄISCHE PATENTSCHRIFT

(11) **EP 0 468 153 B1**
(45) Veröffentlichungstag und Bekanntmachung des Hinweises auf die Patenterteilung: **11.10.1995**
(21) Anmeldenummer: 91107673.5
(22) Anmeldetag: 11.05.1991
(51) Int. Cl.: G01R 31/28, G01R 1/073

(54) **Kontaktierungsvorrichtung für Prüfzwecke**
Device for contacting elements for testing
Dispositif pour contacter des éléments à tester

(30) Priorität: 25.07.1990 DE 4023621; 23.03.1991 DE 4109684
(43) Veröffentlichungstag der Anmeldung: 29.01.1992
(73) Patentinhaber: atg test systems GmbH, 97877 Wertheim (DE); Adaptronic Prüftechnik GmbH, 97877 Wertheim (DE)
(72) Erfinder: Prokopp, Manfred, W-6980 Wertheim-Reicholzheim (DE)
(74) Vertreter: Grosse, Rainer, Dipl.-Ing.

(56) Entgegenhaltungen:
- GB-A- 2 038 489
- US-A- 3 584 741
- RESEARCH DISCLOSURE, Nr. 292, August 1988, Seite 563, Zusammenfassung Nr.29208, New York, US; "Copper peel sensing device"
- IBM TECHNICAL DISCLOSURE BULLETIN, Band 15, Nr. 2, Juli 1972, Seite 364, New York, US; P.M. DeGROAT et al.: "Finding short circuits in multilayer printed-circuit boards and assemblies"

## Beschreibung

Die Erfindung betrifft eine Kontaktierungsvorrichtung, insbesondere für Prüfzwecke, mit mehreren in einem Prüffeld verfahrbaren Positioniergliedern, die je einen auf eine gewünschte Kontaktstelle eines Prüflings aufsetzbaren Kontaktfinger aufweisen, wobei zwei Kontaktfinger ein Sondenpaar bilden, das Bestandteil eines Prüfstromkreises ist, und geht aus von der GB-A-2′038′489.

Es ist bekannt, zum Beispiel als kaschierte Leiterplatten ausgebildete Prüflinge insbesondere vor ihrer Bestückung mit elektronischen Bauteilen einer Prüfung auf Kurzschluß, Isolationswiderstand und/oder Leiterbahnwiderstand zu unterziehen. Hierzu werden -insbesondere bei Großserien- sogenannten Adapter eingesetzt, die eine Vielzahl von Federkontaktstiften aufweisen, welche die Verbindung eines Prüffeldkontaktrasters zu Kontaktstellen des Prüflings herstellen, welche außerhalb dieses Rasters liegen. Da die Entwicklung und Herstellung derartiger Adapter hohe Kosten mit sich bringt, werden bei Kleinserien und zum Beispiel für den Test von Prototypen Kontaktierungsvorrichtungen eingesetzt, die verfahrbare Sondenpaare aufweisen. Jede Sonde besteht aus einem entlang zweier senkrecht aufeinander stehender Koordinaten verfahrbaren Positionierglied, das einen Kontaktfinger aufweist. Hieraus resultiert auch die Benennung "Fingertester" für eine derartige Vorrichtung. Dieser Kontaktfinger wird nach Anfahren der gewünschten Position abgesenkt, so daß er auf die entsprechende Kontaktstelle des Prüflings aufsetzt. Die beiden, dem Sondenpaar zugeordneten Kontaktfinger sind Bestandteil eines Prüfstromkreises, der zum Beispiel eine Hochvolt- und/oder Hochstrommessung oder aber auch eine Impedanzmessung ermöglicht. Die für den Prüfvorgang von den Kontaktfingern anzufahrenden Positionen werden von einem Rechner vorgegeben, in dem das Prüfprogramm gespeichert ist.

Da selbst relativ einfach aufgebaute Prüflinge, zum Beispiel mit nur einer relativ kleinen Anzahl von Leiterbahnen versehene Leiterplatten, eine nicht unerhebliche Anzahl von Prüfschritten und damit Positionsveränderungen der Kontaktfinger erfordert, ergeben sich sehr lange Prüfzeiten. Relativ kurze Prüfzeiten lassen sich mit den eingangs erwähnten Adaptern erzielen, da die einzelnen Federkontaktstifte dieser Adapter auf eine Vielzahl von Kontaktstellen des Prüflings gleichzeitig aufsetzen, so daß -für die Prüfung- nur noch zwischen den einzelnen Federkontaktstiften eine Messung durch mittels Prüfprogramm vorgenommener Umschaltung erfolgen muß. Derartige Adapter sind jedoch -wie eingangs schon erwähnt- extrem teuer und dahin nicht für jeden Anwendungsfall wirtschaftlich geeignet.

Aus der GB-A-2 038 489 ist ein Kontaktierungsvorrichtung bekannt, die mit Linearmotoren angetriebene Positionierglieder aufweist, die über Kabel an eine Steuereinrichtung angeschlossen sind und Kontaktfinger zum Kontaktieren eines Prüflings aufweisen, der sich oberhalb der Positionierglieder befindet. Die Positionierglieder werden für die Prüfung derart verfahren, daß ihre Kontaktfinger der gewünschten Kontaktstelle gegenüberliegen. Anschließend werden die Kontaktfinger zur Kontaktierung verlagert. Um zu einer Kontaktstelle zu gelangen ist es notwendig, das gesamte Positionierglied in die erforderliche Stellung zu verlagern. Dies erfordert entsprechend lange Steuerzeiten, die die Prüfzeit verlängern.

Der Erfindung liegt daher die Aufgabe zugrunde, eine Kontaktierungsvorrichtung der eingangs genannten Art zu schaffen, die lange Prüfzeiten vermeidet und eine hohe Flexibilität aufweist.

Dieser Aufgabe wird erfindungsgemäß dadurch gelöst, daß mehrere Sondenpaare vorhanden sind, deren Positionierglieder an mindestens einer, das Prüffeld überspannenden Traverse verfahrbar lagern und entlang einer ersten und einer zweiten, quer, insbesondere senkrecht, zur ersten verlaufenen Koordinate verfahrbar sind, wobei die Traverse in Richtung der ersten Koordinate verfahrbar ist und die an der Traverse lagernden Positionierglieder unabhängig voneinander in Richtung der zweiten Koordinate verfahrbar sind, und daß die Positionierglieder Schwenkarme aufweisen, an denen die Kontaktfinger angeordnet sind.

Durch die Vielzahl der Sondenpaare können gleichzeitig mehrere Prüfstromkreise ausgebildet werden, so daß -trotz gleichbleibender Anzahl der Prüfschritte- die Prüfzeit erheblich verkürzt wird. Da die Positionierglieder der Sondenpaare unabhängig voneinander verfahrbar sind, können stets derart geeignete Kontaktstellen des Prüflings angefahren werden, daß sich insgesamt ein optimaler Meßlauf einstellt. Eine optimale Positionierung der Kontaktfinger ist dadurch möglich, daß die Positionierglieder Schwenkarme aufweisen, an denen die Kontaktfinger angeordnet sind. Die Positionierglieder lassen sich in Richtung der X- und der Y-Koordinate verfahren. Relativ zu den Positioniergliedern kann der jeweilige Schwenkarm verschwenkt werden, wobei der Schwenkwinkel vorzugsweise 360 Grad, also ein Vollkreis, beträgt. Eine Verschwenkung des Schwenkarms hat zur Folge, daß der am freien Ende des Schwenkarms angeordnete Kontaktfinger sowohl eine Bewegung entlang der X-Koordinate, als auch eine Bewegung entlang der Y-Koordinate durchführt. Durch eine entsprechende Abstimmung zwischen den Steuerdaten für das Positionierglied und für den zugehörigen Schwenkarm kann innerhalb kürzester Zeit und auf sehr kurzem Wege jede zu kontaktierende Kontaktstelle angefahren werden. Bei engen Abmessungen lassen sich stets günstige Schwenkwinkel bestimmen. Dies gilt sowohl innerhalb der Bereiche (Segmente) des Prüffelds als auch in überlappenden Randzonen oder Grenz- bzw. Eckbereichen. Grundsätzlich ist es möglich, die mit Kontaktfinger versehen Positionierglieder mit konventionellen Antriebseinrichtungen zu verfahren. Hier sei beispielsweise ein mit Kugelumlaufspindel versehener Antrieb genannt, d. h., das einzelne Positionierglied wird linear geführt und entlang der Führung mittels der Kugelumlaufspindel verlagert. Vorzugsweise kommen dabei Regeleinrichtungen zum Einsatz. Die Ist-Position des Positionierglieds wird insbesondere mit Hilfe eines Heidenhain-Linear-Glasmaßstabs ermittelt und -entsprechend vom Rechner vorgegebener Soll-Position- korrigiert, so daß sich keine Regeldifferenz einstellt.

Nach einer bevorzugten Ausführungsform der Erfindung sind mindestens zwei das Prüffeld überspannende Traversen vorgesehen, wobei jeweils mindestens zwei Positionierglieder an jeder Traverse angeordnet sind, sowie die Positionierglieder entlang jeder Traverse in Richtung der einen Koordinate und die Traverse quer dazu entlang der anderen Koordinate verfahrbar sind. Mithin liegt eine Anordnung vor, die mit einer aus der Werkzeugmaschinentechnik bekannten Kreuzschlittenausbildung vergleichbar ist. Erfindungsgemäß besteht jedoch die Besonderheit, daß jeder Traverse mindestens zwei Positionierglieder zugeordnet sind, welche unabhängig voneinander angesteuert werden können. Die jeweils einer Traverse zugehörigen Positionierglieder lassen sich somit unabhängig voneinander entlang einer Koordinate (Längserstreckung der Traverse) verfahren. Quer zu dieser Bewegungsrichtung ist die Traverse verlagerbar, so daß jeder Punkt des Prüffelds anfahrbar ist. Mithin wird -vom Prüfprogramm- die Traverse bei jeder Positionierung in eine vorgegebene Position gefahren, so daß für diesen Prüfschritt die eine der Koordinaten festliegt. Die beiden oder mehreren Positionierglieder lassen sich gleichzeitig -unabhängig voneinander- in die gewünschten Positionen steuern, um ihre Kontaktfinger auf die Kontaktstellen des Prüflings zur Ausbildung der Prüfstromkreise aufzusetzen. Da die Kontaktstellen der Prüflinge -insbesondere wenn es sich um Leiterplatten handelt- von Haus aus oftmals in einem Koordinatenraster angeordnet sind, ist es kein Nachteil, daß sich die beiden Positionierglieder zwar entlang einer Koordinate unabhängig voneinander positionieren lassen, jedoch im Hinblick auf die andere Koordinate die gleiche Position einnehmen. Stets lassen sich durch ein entsprechendes Prüfprogramm daher bei jedem Prüfschritt mehrere Prüfstromkreise gleichzeitig ausbilden.

Bevorzugt läßt sich jedes Positionierglied und/oder jede Traverse mittels einer separaten Antriebseinrichtung verfahren. Dabei können die -zuvor bereits erwähnten- konventionellen Antriebseinrichtungen verwendet werden. Diese sind vorzugsweise als Servomotoren ausgebildet und mit den Kugelumlaufspindeln versehen. Insbesondere ist es jedoch auch möglich als Antriebseinrichtungen Linearmotoren zu verwenden. Diese arbeiten entlang einer Koordinate, das heißt, der Traverse ist für ihre Verlagerung ein Linearmotor und den an der Taverse angeordneten Positioniergliedern ein oder mehrere andere Linearmotoren zugeordnet. Auch hier ist es möglich, mindestens zwei Positionierglieder über einen Linearmotor anzusteuern, sofern diese durch eine geeignete Steuerungskodierung getrennt voneinander betätigbar sind.

Besonders vorteilhaft ist es, wenn die Positionierglieder derart angeordnet sind, daß mit ihren Kontaktfingern die Vorder- und Rückseite des Prüflings kontaktierbar ist. Dieses bringt insbesondere bei beidseitig kaschierten Leiterplatten den Vorteil, daß gleichzeitig eine Vielzahl von Prüfungen stattfinden kann, ohne daß sich die Positionierglieder gegenseitig behindern. Ferner ist durch die beidseitige Kontaktierung sichergestellt, daß durch die Kontaktierungskräfte kein Durchbiegen der Leiterplatten auftritt, da diese ja dann von beiden Seiten wirken.

Nach einer weiteren Ausführungsform ist vorgesehen, daß zur gleichzeitigen Prüfung von Vorder- und Rückseite des Prüflings diesem jeweils mindestens zwei Traversen zugeordnet sind. Insofern können die jeder Seite des Prüflings zugeordneten beiden Traversen jeweils zwei Prüfstromkreise auf jeder Seite ausbilden, sofern jede Traverse zwei Kontaktfinger aufweist. Bei einer größeren Anzahl von Traversen bzw. von den Traversen zugeordneten Kontaktfingern, läßt sich die Anzahl der Prüfstromkreise pro Prüfschritt noch erhöhen. Auch ist es insbesondere bei durchkontaktierten Leiterplatten möglich, daß zwischen Kontaktfingern unterschiedlicher Seiten des Prüflings Prüfstromkreise gebildet werden.

Besonders bevorzugt ist es, wenn die Positionierglieder entlang vertikaler Ebenen verfahrbar sind. Dieses unterstellt, daß der Prüfling senkrecht angeordnet wird. Ein als Leiterplatte ausgebildeter Prüfling wird somit in vertikaler Position angeordnet und dann -insbesondere beidseitig- mit den Kontaktfingern beaufschlagt. Diese senkrechte Anordnung des Prüflings hat neben der besonders günstigen Zugänglichkeit ferner den Vorteil, daß die Schwerkraft keine Verformung der oft relativ dünnwandigen Leiterplatten bewirken kann. Insofern ergibt sich eine sehr eng tolerierte Positioniergenauigkeit und Kontaktfindung, was die Meßsicherheit erheblich erhöht.

Insbesondere ist eine Steuereinrichtung vorgesehen, die die Antriebseinrichtungen derart ansteuert, daß die Positionierglieder und/oder Sondenpaare kollisionsfrei möglichst kurze Wege von Prüfschritt zu Prüfschritt zurücklegen.

Ferner ist es besonders vorteilhaft, wenn die Steuereinrichtung mehr als zwei Positionierglieder gleichzeitig derart ansteuert, daß bei einer Positionierung alle gewünschten Kombinationen von Prüfstromkreisen zwischen den zugehörigen Kontaktfingern gebildet und ausgewertet werden. Hierdurch ist es möglich, daß -ohne eine Neupositionierung vorzunehmen- durch die Vielzahl der auszubildenden Prüfstromkreiskombinationen eine optimale Prüfung und in sofern eine extrem hohe Prüfsicherheit erzielbar ist. Durch die Auswahl geeigneter Prüfstromkreise lassen sich Rückschlüsse auf den Prüflingszustand erzielen, ohne daß es einer Messung bedarf. Diese sogenannte Erstellung von kombinatorischen Prüfergebnissen reduziert die Anzahl der Prüf- und Positionierschritte und damit die Prüfzeit.

Vorzugsweise ist vorgesehen, daß das Prüffeld in virtuelle Bereiche unterteilt ist, wobei jedem Bereich mindestens ein Sondenpaar zugeordnet ist. Diese Segmentierung erlaubt es, die jedem Bereich (Segment) zugeordneten Kontaktfinger optimal zu nutzen. Vorzugsweise werden die Bereiche des Prüffelds unterschiedlich groß ausgewählt. Dabei ist die Größe des jeweiligen Bereichs umgekehrt proportional der Anzahl der zu kontaktierenden Kontaktstellen. Dies hat zur Folge, daß mit relativ vielen Kontaktstellen versehene Bereiche des Prüffelds aufgrund der Unterteilung in entsprechend viele Bereiche gegenüber mit weniger Kontaktstellen versehenen Bereichen des Prüffelds, wobei die zuletzt genannten Bereiche entsprechend größer gewählt sind, in etwa gleicher Prüfzeit geprüft werden. Damit läßt sich die Prüfung des gesamten Prüflings in optimal kurzer Zeit durchführen. Ferner kann jedem Bereich eine spezielle Prüfsoftware zugeordnet sein, so daß die Koordination der Bewegungen der Kontaktfinger bereichsweise optimal gesteuert wird.

Nach einem besonderen Ausführungsbeispiel der Erfindung ist vorgesehen, daß die Bereiche als über die Breite beziehungsweise Länge des Prüffelds verlaufende Streifen ausgebildet sind. Die Grenzen der Bereiche, insbesondere der Streifen, können auf Konstanten X- beziehungsweise Y-Koordinaten liegen.

Vorzugsweise können sich benachbarte Bereiche mit ihren Randzonen überlappen. In diesen Überlappungsbereichen stehen für den Fall, daß jedem Bereich ein Sondenpaar zugeordnet ist, vier Kontaktfinger gleichzeitig zur Verfügung. Vorzugsweise ist dann eine Kollisionssoftware vorgesehen, die eine Kollision der Kontaktfinger im Überlappungsbereich verhindert. Eine entsprechende Kollisionssoftware ist selbstverständlich auch jedem Bereich als solchen zugeordnet, um die zugehörigen Kontaktfinger ohne Kollision zu verfahren.

Um jeden Punkt auf einfache Weise innerhalb eines Bereichs beziehungsweise Streifens anfahren zu können, wird vorzugsweise die Breite des Bereichs beziehungsweise Streifens kleiner als die Reichweite des an dem zugehörigen Schwenkarm angeordneten Kontaktfinger gewählt. Dies soll für ein stillstehendes Positionierglied gelten.

Die Zeichnung veranschaulicht die Erfindung anhand von zwei Ausführungsbeispielen. Und zwar zeigt:
- Figur 1: eine schematische Draufsicht auf eine Kontaktierungsvorrichtung,
- Figur 2: eine schematische Schnittansicht einer Kontaktierungsvorrichtung,
- Figur 3: eine schematische Draufsicht auf eine weitere Kontaktierungsvorrichtung und
- Figur 4: ein Beispiel für eine optimale Verfahrbarkeit der Kontaktfinger einer Kontaktierungsvorrichtung gemäß Figur 3.

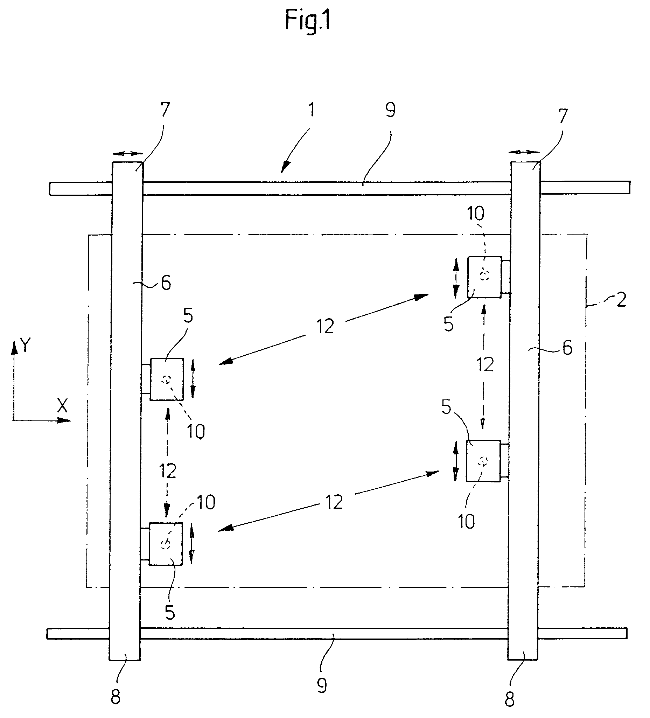

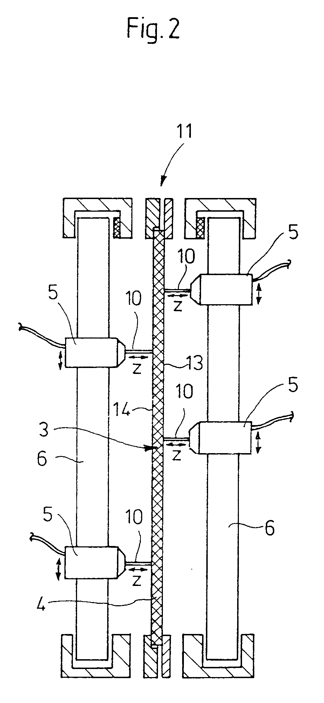

Die Figur 1 zeigt eine schematische Ansicht einer Kontaktierungsvorrichtung 1, wobei nur die für die Erfindung wesentlichen Komponenten dargestellt sind. Insofern sind ebenfalls für die Funktion dieser Vorrichtung erforderliche, jedoch für die Erfindung unwesentliche Teile weggelassen. In den Figuren 1 und 2 sind -zur allgemeinen Erläuterung-Kontaktierungsvorrichtungen dargestellt, die jedoch nicht mit Schwenkarmen gemäß dem Gegenstand der Erfindung versehen sind.

Die Kontaktierungsvorrichtung 1 weist ein Prüffeld 2 auf, das der Aufnahme eines Prüflings 3 dient (Figur 2). Bei dem Prüfling 3 handelt es sich vorzugsweise um eine mit Leiterbahnen versehene Leiterplatte 4. Diese Leiterplatte 4 ist mit einer Vielzahl von Bohrungen zur Aufnahme von elektronischen Bauteilen versehen (nicht dargestellt). Vor dem Bestücken der Leiterplatte 4 wird diese im Prüffeld 2 einer Isolations-, Kurzschluß- und/oder Widerstandsprüfung unterzogen, so daß nur die Leiterplatten 4, die einwandfreie Funktionen aufweisen, in einem weiteren Bearbeitungsschritt mit Bauelementen bestückt werden. Die defekten Leiterplatten 4 werden ausgesondert und gegebenenfalls einer Fehlerbehebung unterzogen.

Um die genannte elektrische Prüfung durchführen zu können, weist die Kontaktierungsvorrichtung 1 entlang von zwei, senkrecht zueinander verfahrbaren Koordinaten x, y verfahrbare Positionierglieder 5 auf. Hierzu wird das Prüffeld 2 von zwei Traversen 6 überspannt, wobei jede Traverse 6 in ihren Endbereichen 7 und 8 an Führungen 9 gelagert ist. Mittels einer nicht näher dargestellten Antriebseinrichtung läßt sich daher jede Traverse 6 entlang der Koordinate x verfahren.

Wie aus Figur 1 ersichtlich sind an jeder Traverse 6 mindestens zwei Positionierglieder 5 verfahrbar angeordnet. Die Längserstreckung jeder Traverse 6 verläuft in Richtung der Koordinate y, so daß die Positionierglieder 5 in Richtung dieser Koordinate verlagerbar sind. Für das Verfahren der Positionierglieder 5 sind wiederum nicht näher dargestellte Antriebseinrichtungen vorgesehen.

Gemäß Figur 2 weist jedes Positionierglied 5 einen Kontaktfinger 10 auf, der -beim Verfahren des zugehörigen Positioniergliedes 5 vom Prüfling 3 beabstandet ist und -nach Erreichen der gewünschten Position des Positionierglieds 5- zur Kontaktierung auf eine gewünschte Kontaktstelle des Prüflings 3 aufgesetzt werden kann. Insofern ist jeder Kontaktfinger in Richtung der Koordinate z verlagerbar.

Es ist insbesondere der Figur 2 zu entnehmen, daß die den Prüfling 3 bildende Leiterplatte 4 in vertikaler Stellung, das heißt, also mit vertikaler Leiterplattenebene, in der Kontaktierungsvorrichtung 1 zur Durchführung der Prüfung angeordnet wird. Hierzu sind geeignete Befestigungsmittel 11 vorgesehen, die während des Prüfvorgangs die Leiterplatte 4 halten.

Es ist vorgesehen, daß von den mit Kontaktfingern 10 versehenen Positioniergliedern 5 mehrere Sondenpaare 12 gebildet werden. Dies ist beispielsweise in der Figur 1 angedeutet; dort bilden die oberen beiden Positionierglieder 5 der beiden Traversen 6 ein erstes Sondenpaar 12 und die unteren beiden Positionierglieder 5 ein zweites Sondenpaar 12. Es ist jedoch -je nach dem vorliegenden Programmprüfungsschritt- möglich, daß die beiden Positionierglieder 5 derselben Traverse 6 für diesen bestimmten Programmschritt ein Sondenpaar 12 bilden (dies ist in der Figur 1 mit gestrichelten Doppelfeilen gekennzeichnet).

Durch die Vielzahl der Sondenpaare 12 ist innerhalb eines Positionierschritts eine entsprechende Anzahl von Prüfstromkreisen ausbildbar. Unter Prüfstromkreis ist hier eine elektrische Prüfung entlang eines Strompfades zu verstehen, der -von einer nicht dargestellten Auswerteelektronik kommend- zu einem der Positionierglieder 5 führt, über den Prüfling 3 verläuft und über das zum betrachtenden Sondenpaar 12 zugehörige Positionierglied 5 zur Auswerteelektronik zurückführt. Ein weiterer, entsprechender Prüfstromkreis wird zwischen den verbleibenden Positioniergliedern 5 ausgebildet, so daß -je nach Anzahl der Positionierglieder 5 und damit der möglichen Prüfstromkreise gleichzeitig eine Vielzahl von Prüfungen durchführbar sind. Innerhalb eines Prüfschritts ist es selbstverständlich auch möglich, daß zwischen den einzelnen Positioniergliedern 5 unterschiedliche Prüfstromkreise ausgebildet werden; mithin die verschiedenen Kombinationen von Prüfstromkreisen hergestellt und meßtechnisch ausgewertet werden. So kann zum Beispiel das in der Figur 1 oben rechts dargestellte Positionierglied 5 sowohl mit dem auf gleicher y-Koordinate liegenden Positionierglied 5 in einem Prüfstromkreis liegen und anschließend dann ein Prüfstromkreis zwischen dem zuerst erwähnte Positionierglied 5 und einem der Positionierglieder 5 der linksseitigen Traverse 6 gebildet werden. Ist dies erfolgt, so bleibt noch eine weitere Möglichkeit, nämlich ein Prüfstromkreis mit dem verbleibenden Positionierglied 5 der linksseitigen Traverse 6 zu erzeugen. Hieraus wird deutlich, daß nicht nur eine besonders komplexe Prüfung möglich ist, die eine hohe Meßsicherheit garantiert, sondern daß es nicht erforderlich ist, bei der Umschaltung zur Ausbildung der verschiedenen Prüfstromkreise eine Neupositionierung der Positionierglieder 5 vorzunehmen.

Die Figur 2 zeigt, daß sowohl der Vorderseite 13 als auch der Rückseite 14 der Leiterplatte 4 jeweils mit Positioniergliedern 5 versehene Traversen 6 zugeordnet sind. Beispielsweise ist es möglich, der Vorder- und der Rückseite 13, 14 des Prüflings 3 jeweils zwei Traversen 6 mit jeweils zwei Positioniergliedern 5 zuzuordnen. Es liegt jedoch auch im Rahmen der Erfindung, mehr als zwei Positionierglieder 5 an einer Traverse 6 vorzusehen und/oder jede Seite des Prüflings 3 mit mehr als zwei Traversen 6 auszustatten.

Zur Positionierung der Positionierglieder 5 sind -wie bereits erwähnt- Antriebseinrichtungen vorgesehen, mit denen einerseits die Traversen 6 und andererseits die Positionierglieder 5 verfahren werden können. Wesentlich ist, daß sich die Positionierglieder 5 stets unabhängig voneinander verfahren lassen. Dies bedeutet, daß die quasi entlang einer gemeinsamen Achse (Koordinate y) verlagerbaren Positionierglieder 5 einer Traverse 6 unabhängig voneinander in die jeweils gewünschte Position gebracht werden können. Ferner sind auch die Traversen 6 -nicht abhängig davon, ob sie auf der gleichen Seite oder auf unterschiedlichen Seiten des Prüflings 3 angeordnet sind- unabhängig voneinander verlagerbar.

Als Antriebseinrichtungen kommen vorzugsweise Servomotoren in Frage. Diese sind innerhalb eines Regelkreises angeordnet, so daß die von einem Rechner der Kontaktierungsvorrichtung 1 vorgegebene Soll-Position durch einen Soll/Ist-Vergleich exakt angefahren werden kann. Zur Ermittlung der Istposition ist vorzugsweise ein (nicht dargestellter) Heidenhain-Linear-Glasmaßstab vorgesehen.

Nach einem besonders bevorzugten Ausführungsbeispiel sind als Antriebseinrichtungen Linearmotoren verwendet. Mithin lassen sich sowohl die Traversen 6 unabhängig voneinander mit Linearmotoren entlang der Koordinate x und die einzelnen Positionierglieder 5 entlang der Längserstreckung der zugehörigen Traversen 6 unabhängig voneinander verfahren.

Eine codierte Ansteuerung stellt sicher, daß von einer (nicht dargestellten) Steuereinrichtung des bereits erwähnten Rechners nur das jenige Positionierglied 5 angesprochen wird, das verlagert werden soll. Bei dem Ausführungsbeispiel der Figur 1 ist eine derartige Kodierung bei Verwendung von Linearmotoren vorgesehen, so daß die einer Traverse 6 zugeordneten Positionierglieder 5 unabhängig voneinander verlagerbar sind. Dies gilt auch für die unabhängige Verlagerung der Traversen 6 untereinander.

Die genannte Steuereinrichtung stellt durch ein geeignetes Programm sicher, daß die Antriebseinrichtungen (seien sie nun als mit Kugelspindelantrieb versehene Servomotoren oder Linearmotoren) die Positionierglieder 5 und/oder die von diesen gebildeten Sondenpaare 12 kollisionsfrei auf möglichst kurzem Wege die für den jeweiligen Prüfschritt erforderlichen Positionen einnehmen. Überdies ist sichergestellt, daß -für ein besonders effektives Arbeiten -mehr als zwei Positionierglieder gleichzeitig derart in Position gebracht werden, daß bei einem einzigen Positionierschritt alle gewünschten Kombinationen von Prüfstromkreisen zwischen den zugehörigen Kontaktfingern 10 gebildet und ausgewertet werden. Insofern kann in manchen Fällen durch eine entsprechende Auswertung aufgrund logischer Verknüpfung auf mögliche Fehler oder Funktionstüchtigkeiten geschlossen werden, ohne daß es hierzu einer Messung bedarf. Überdies stellt diese Vorgehensweise sicher, daß möglichst wenig Positionsänderungen für den Gesamtprüfvorgang einer Leiterplatte 4 erforderlich sind.

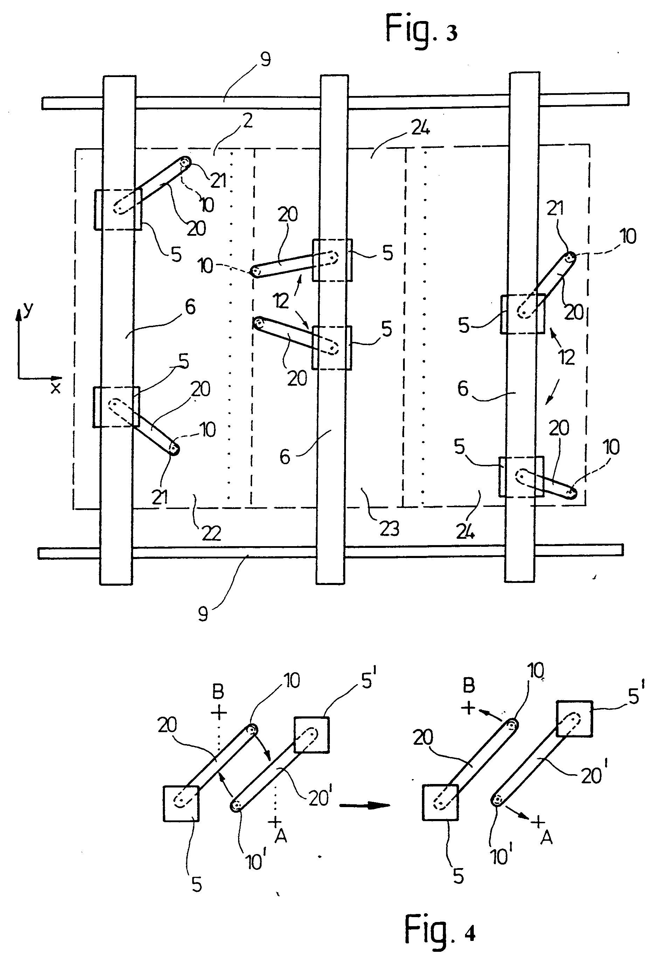

Die Figur 3 zeigt eine Kontaktierungsvorrichtung, die sich gegenüber dem Ausführungsbeispiel der Figur 1 dadurch unterscheidet, daß die Positionierglieder 5 mit Schwenkarmen 20 versehen sind. Die einzelnen Positionierglieder 5 sind an Traversen 6 in Richtung der Y-Koordinate verfahrbar. Vorzugsweise sind jeder Traverse 6 zwei Positionierglieder 5 zugeordnet. Es können jedoch auch mehr als zwei gewählt werden. Die Traversen 6 lassen sich entlang der Führungen 9 in Richtung der X-Koordinate verfahren.

Jeder Schwenkarm 20 ist an seinem einen Ende am zugehörigen Positionierglied 5 gelagert und in einer parallel zum Prüffeld 2 liegenden Ebene verschwenkbar, wobei der Schwenkwinkel vorzugsweise 360° beträgt. Am freien Ende 21 jedes Schwenkarms 20 ist ein Kontaktfinger 10 angeordnet, der in Richtung der Z-Koordinate auf das Prüffeld 2 zum Kontaktieren einer Kontaktstelle eines Prüflings abgesenkt werden kann. Dabei besteht die Möglichkeit, daß sich der Kontaktfinger 10 absenkt oder daß der gesamte Schwenkarm 20 oder die Positioniervorrichtung 5 verlagert wird.

Die Figur 4 verdeutlicht, daß stets günstige Schwenkwinkel der Schwenkarme 20 bei der Positionierung zum Kontaktieren von Kontaktstellen durchfahren werden können. Soll beispielsweise mit dem Kontaktfinger 10 des Schwenkarms 20 die Kontaktstelle A und mit dem Kontaktfinger 10′ des Schwenkarms 20′ die Kontaktstelle B gemäß der in der Figur 5 (linke Seite) dargestellten Stellungen der Positionierglieder 5 und 5′ angefahren werden, so würden die beiden Schwenkarme 20 und 20′ miteinander kollidieren, wenn sie entlang der mit den Pfeilen gekennzeichneten Wege verschwenkt würden. Auf der rechten Seite der Figur 4 ist dargestellt, wie eine Kollision mittels einer Kollisionssoftware verhindert werden kann, wobei gleichzeitig günstige Wege und damit kurze Prüfzeiten realisiert werden. Die Kollisionssoftware vertauscht die Ansteuerung, indem sie den Kontaktfinger 10 der Kontaktstelle B und den Kontaktfinger 10′ der Kontaktstelle A zuordnet. Damit verkleinern sich die einzelnen Schwenkwinkel der Schwenkarme 20 und 20′ erheblich, wobei gleichzeitig keine Kollision mehr stattfinden kann.

Die Figur 3 zeigt noch eine weitere Besonderheit der erfindungsgemäßen Kontaktierungsvorrichtung auf, die eine optimale Prüfung zuläßt. Hierzu ist das Prüffeld 2 in Bereiche 22, 23 und 24 unterteilt, wobei jedem Bereich 22, 23 und 24 mindestens ein Sondenpaar 12 zugeordnet ist. Die Bereiche 22, 23 und 24 sind mit jeweils einer Punkt-Linie voneinander abgegrenzt. Die Größe der Bereiche wird in Abhängigkeit von der Dichte der im jeweiligen Bereich liegenden Kontaktstellen gewählt, so daß es durchaus möglich ist, daß die Bereiche 22, 23 und 24 unterschiedliche Größe aufweisen. Es kann auch bei einer hohen Kontaktstellendichte bei einigen oder allen Bereichen vorgesehen sein, daß mehr als ein Sondenpaar 12 diesem jeweiligen Bereich zugeordnet ist. Die Sonden jedes Sondenpaars können einer Traverse oder verschiedenen Traversen angehören. Insbesondere wird derart vorgegangen, daß die Bereiche 22, 23 und 24 als Streifen ausgebildet sind, wobei die Grenzen der Bereiche auf konstanten X- beziehungsweise Y-Koordinaten liegen.

Betrachtet man zum Beispiel einen als Streifen 24 ausgebildeten Bereich der Figur 3, der durch die beiden Strich-Linien zu den Nachbarbereichen abgegrenzt ist, so wird deutlich, daß seine Breite kleiner als die Reichweite der zugehörigen Schwenkarme 20 bei stillstehendem Positionierglied 5 und/oder Traverse ist. Durch diese Wahl lassen sich auch ohne Verfahren der zugeordneten Traverse 6 alle in diesem Streifen liegenden Kontaktstellen anfahren oder es sind -für eine Optimierung- nur kleine Fahrstrecken der Traverse 6 durchzuführen, um dann auf kürzestem Wege beziehungsweise in kürzester Zeit die jeweils zu kontaktierende Kontaktstelle zu erreichen.

## Patentansprüche

1. Kontaktierungsvorrichtung (1), insbesondere für Prüfzwecke, mit mehreren in einem Prüffeld (2) verfahrbaren Positioniergliedern (5, 5′), die je einen auf eine gewünschte Kontaktstelle eines Prüflings aufsetzbaren Kontaktfinger (10, 10′) aufweisen, wobei zwei Kontaktfinger (10, 10′) ein Sondenpaar (12) bilden, das Bestandteil eines Prüfstromkreises ist, **dadurch gekennzeichnet**, daß mehrere Sondenpaare (12) vorhanden sind, deren Positionierglieder (5, 5′) an mindestens einer, das Prüffeld überspannenden Traverse (6) verfahrbar lagern und entlang einer ersten und einer zweiten, quer, insbesondere senkrecht, zur ersten verlaufenden Koordinate verfahrbar sind, wobei die Traverse (6) in Richtung der ersten Koordinate (X) verfahrbar ist und die an der Traverse (6) lagernden Positionierglieder (5, 5′) unabhängig voneinander in Richtung der zweiten Koordinate (Y) verfahrbar sind, und daß die Positionierglieder (5, 5′) Schwenkarme (20, 20′) aufweisen, an denen die Kontaktfinger (10, 10′) angeordnet sind.

2. Kontaktierungsvorrichtung nach Anspruch 1, **dadurch gekennzeichnet**, daß jeder Schwenkarm (20,20′) in einer parallel zur Ebene des Prüffelds (2) liegenden Ebene verschwenkbar ist.

3. Kontaktierungsvorrichtung nach einem der vorhergehenden Ansprüche, **dadurch gekennzeichnet**, daß der Schwenkwinkel des Schwenkarms (20,20′) 360° beträgt.

4. Kontaktierungsvorrichtung nach einem der vorhergehenden Ansprüche, **gekennzeichnet durch** mindestens zwei das Prüffeld (2) überspannende Traversen (6), wobei jeweils mindestens zwei Positionierglieder (5) an jeder Traverse (6) angeordnet sind.

5. Kontaktierungsvorrichtung nach einem der vorhergehenden Ansprüche, **dadurch gekennzeichnet**, daß jedes Positionierglied (5) und/oder jede Traverse (6) mittels einer separaten Antriebseinrichtung verfahrbar ist.

6. Kontaktierungsvorrichtung nach einem der vorhergehenden Ansprüche, **dadurch gekennzeichnet**, daß die Antriebseinrichtungen als Servomotoren ausgebildet sind.

7. Kontaktierungsvorrichtung nach einem der vorhergehenden Ansprüche 1 bis 3, **dadurch gekennzeichnet**, daß die Antriebseinrichtungen als Linearmotoren ausgebildet sind.

8. Kontaktierungsvorrichtung nach einem der vorhergehenden Ansprüche, **dadurch gekennzeichnet,** daß die Positionierglieder (5) derart angeordnet sind, daß mit ihren Kontaktfingern (10) die Vorder- und Rückseite (13,14) des Prüflings (3) kontaktierbar ist.

9. Kontaktierungsvorrichtung nach einem der vorhergehenden Ansprüche, **dadurch gekennzeichnet**, daß zur gleichzeitigen Prüfung von Vorder- und Rückseite (13,14) des Prüflings (3) diesen mindestens jeweils zwei Traversen (6) zugeordnet sind.

10. Kontaktierungsvorrichtung nach einem der vorhergehenden Ansprüche, **dadurch gekennzeichnet**, daß die Positionierglieder (5) entlang vertikaler Ebenen verfahrbar sind.

11. Kontaktierungsvorrichtung nach einem der vorhergehenden Ansprüche, **gekennzeichnet durch** eine Steuereinrichtung, die die Antriebseinrichtungen derart ansteuert, daß die Positionierglieder (5) und/oder Sondenpaare (12) kollisionsfrei möglichst kurze Wege von Prüfschritt zu Prüfschritt zurücklegen.

12. Kontaktierungsvorrichtung nach einem der vorhergehenden Ansprüche, **dadurch gekennzeichnet,** daß die Steuereinrichtung mehr als zwei Positionierglieder (5) gleichzeitig derart ansteuert, daß bei einer Positionierung alle gewünschten Kombinationen von Prüfstromkreisen zwischen den zugehörigen Kontaktfingern (10), vorzugsweise unter Reduzierung der Anzahl der Prüfschritte aufgrund einer Erstellung von kombinatorischen Prüfergebnissen, gebildet und ausgewertet werden.

13. Kontaktierungsvorrichtung nach einem der vorhergehenden Ansprüche, **dadurch gekennzeichnet**, daß das Prüffeld (2) in virtuelle Bereiche (22,23,24) unterteilt ist, wobei jedem Bereich (22,23,24) mindestens ein Sondenpaar (12) zugeordnet ist.

14. Kontaktierungsvorrichtung nach Anspruch 13, **dadurch gekennzeichnet**, daß die Bereiche (22,23,24) des Prüffelds (2) unterschiedlich groß sind.

15. Kontaktierungsvorrichtung nach einem der Ansprüche 13-14, **dadurch gekennzeichnet,** daß die Größe der Bereiche (22,23,24) umgekehrt proportional zur Anzahl der zu kontaktierenden Kontaktstellen des jeweiligen Bereichs (22,23,24) gewählt ist.

16. Kontaktierungsvorrichtung nach einem der Ansprüche 13-15, **dadurch gekennzeichnet**, daß die Bereiche (22,23,24) als über die Breite beziehungsweise Länge des Prüffelds (2) verlaufende Streifen (24) ausgebildet sind.

17. Kontaktierungsvorrichtung nach Anspruch 16, **dadurch gekennzeichnet**, daß die Breite eines Streifens (24) kleiner als die Reichweite des an dem zugehörigen Schwenkarm (20) angeordneten Kontaktfingers (10) gewählt ist.

18. Kontaktierungsvorrichtung nach einem der Ansprüche 13-17, **dadurch gekennzeichnet**, daß die Grenzen der Bereiche (22,23,24) auf konstanten X- beziehungsweise Y-Koordinaten liegen.

19. Kontaktierungsvorrichtung nach einem der Ansprüche 13-18, **dadurch gekennzeichnet**, daß sich benachbarte Bereiche (22,23,24) mit ihren Randzonen uberlappen.

## Claims

1. A contacting device (1), in particular for testing purposes, comprising a plurality of positioning members (5, 5′) displaceable in a test field (2) and each having a contact finger (10, 10′) placeable on a desired contact point on a test piece, two contact fingers (10, 10′) forming a probe pair (12) being a component of a test circuit, characterised in that a plurality of probe pairs (12) are provided, the positioning members (5, 5′) of which are displaceably mounted on at least one crossbar (6) traversing the test field and are displaceable along a first co-ordinate and a second co-ordinate extending transversely, in particular perpendicularly, to the first co-ordinate, the crossbar (6) being displaceable in the direction of the first co-ordinate (X) and the positioning members (5, 5′) mounted on the crossbar (6) being displaceable independently of each other in the direction of the second co-ordinate (Y), and in that the positioning members (5, 5′) have swivel arms (20, 20′) on which the contact fingers (10, 10′) are arranged.

2. A contacting device according to claim 1, characterised in that each swivel arm (20, 20′) is rotatable in a plane parallel to the plane of the test field (2).

3. A contacting device according to either one of the preceding claims, characterised in that the swivel angle of the swivel arm (20, 20′) is 360°.

4. A contacting device according to any one of the preceding claims, characterised by at least two crossbars (6) traversing the test field (2), at least two positioning members (5) being arranged on each crossbar (6).

5. A contacting device according to any one of the preceding claims, characterised in that each positioning member (5) and/or each crossbar (6) is displaceable by means of a separate drive device.

6. A contacting device according to any one of the preceding claims, characterised in that the drive devices are formed as servomotors.

7. A contacting device according to any one of the preceding claims 1 to 3, characterised in that the drive devices are formed as linear motors.

8. A contacting device according to any one of the preceding claims, characterised in that the positioning members (5) are arranged in such a manner that the contact fingers (10) thereof can contact the front and rear (13, 14) of the test piece (3).

9. A contacting device according to any one of the preceding claims, characterised in that, in order to test the front and rear (13, 14) of the test piece (3) simultaneously, at least two crossbars (6) are associated therewith.

10. A contacting device according to any one of the preceding claims, characterised in that the positioning members (5) are displaceable along vertical planes.

11. A contacting device according to any one of the preceding claims, characterised by a control device which activates the drive devices in such a manner that the positioning members (5) and/or probe pairs (12) cover distances as short as possible from test step to test step without collision.

12. A contacting device according to any one of the preceding claims, characterised in that the control device activates more than two positioning members (5) simultaneously in such a manner that, in one positioning action, all the desired combinations of test circuits between the associated contact fingers (10) are formed and evaluated, preferably with a reduction in the number of test steps by providing combinatorial test results.

13. A contacting device according to any one of the preceding claims, characterised in that the test field (2) is divided into virtual regions (22, 23, 24), at least one probe pair (12) being associated with each region (22, 23, 24).

14. A contacting device according to claim 13, characterised in that the regions (22, 23, 24) of the test field (2) differ in size.

15. A contacting device according to either one of claims 13 and 14, characterised in that the size of the regions (22, 23, 24) is inversely proportional to the number of contact points to be contacted in each respective region (22, 23, 24).

16. A contacting device according to any one of claims 13 to 15, characterised in that the regions (22, 23, 24) are formed as strips (24) extending over the width or length of the test field (2).

17. A contacting device according to claim 16, characterised in that the width of a strip (24) is smaller than the range of the contact finger (10) arranged on the associated swivel arm (20).

18. A contacting device according to any one of claims 13 to 17, characterised in that the boundaries of the regions (22, 23, 24) lie on constant X and Y co-ordinates.

19. A contacting device according to any one of claims 13 to 18, characterised in that the edge zones of adjacent regions (22, 23, 24) overlap.

## Revendications

1. Dispositif de mise en contact (1), notamment à des fins de test, avec plusieurs éléments de positionnement (5, 5′) qui peuvent être déplacés dans un champ de test (2) et qui présentent chacun un doigt de contact (10, 10′) pouvant être posé sur un point de contact souhaité d'une pièce à tester, deux doigts de contact (10, 10′) formant une paire de sondes (12) qui fait partie d'un circuit de courant de test, **caractérisé** en ce que plusieurs paires de sondes (12) sont présentes, dont les éléments de positionnement (5, 5′) sont montés à déplacement sur au moins une traverse (6) couvrant le champ de test et peuvent être déplacés le long d'une première coordonnée et d'une deuxième coordonnée s'étendant transversalement et notamment perpendiculairement à la première, la traverse (6) pouvant être déplacée dans la direction de la première coordonnée (X) et les éléments de positionnement (5, 5′) montés sur la traverse (6) pouvant être déplacés indépendamment les uns des autres dans la direction de la deuxième coordonnée (Y), et en ce que les éléments de positionnement (5, 5′) présentent des bras pivotants (20, 20′) sur lesquels sont disposés les doigts de contact (10, 10′).

2. Dispositif de mise en contact selon la revendication 1, **caractérisé** en ce que chaque bras pivotant (20, 20′) peut être pivoté dans un plan parallèle au plan du champ de test (2).

3. Dispositif de mise en contact selon une des revendications précédentes, **caractérisé** en ce que l'angle de pivotement du bras pivotant (20, 20′) est égal à 360°.

4. Dispositif de mise en contact selon une des revendications précédentes, **caractérisé** par au moins deux traverses (6) couvrant le champ de test (2), au moins deux éléments de positionnement respectifs (5) étant disposés sur chaque traverse (6).

5. Dispositif de mise en contact selon une des revendications précédentes, **caractérisé** en ce que chaque élément de positionnement (5) et/ou chaque traverse (6) peut être déplacé(e) au moyen d'un dispositif d'entraînement séparé.

6. Dispositif de mise en contact selon une des revendications précédentes, **caractérisé** en ce que les dispositifs d'entraînement sont réalisés sous la forme de servomoteurs.

7. Dispositif de mise en contact selon une des revendications précédentes 1 à 3, **caractérisé** en ce que les dispositifs d'entraînement sont réalisés sous la forme de moteurs linéaires.

8. Dispositif de mise en contact selon une des revendications précédentes, **caractérisé** en ce que les éléments de positionnement (5) sont disposés de telle sorte que leurs doigts de contact (10) peuvent être mis en contact avec la face avant et la face arrière (13,14) de la pièce à tester (3).

9. Dispositif de mise en contact selon une des revendications précédentes, **caractérisé** en ce qu'afin de tester simultanément la face avant et la face arrière (13,14) de la pièce à tester (3), au moins deux traverses (6) sont respectivement associées à ces dernières.

10. Dispositif de mise en contact selon une des revendications précédentes, **caractérisé** en ce que les éléments de positionnement (5) peuvent être déplacés le long de plans verticaux.

11. Dispositif de mise en contact selon une des revendications précédentes, **caractérisé** par un dispositif de commande qui asservit les dispositifs d'entraînement de telle sorte que les éléments de positionnement (5) et/ou les paires de sondes (12) accomplissent sans collisions des déplacements les plus courts possibles d'une étape de test à l'autre.

12. Dispositif de mise en contact selon une des revendications précédentes, **caractérisé** en ce que le dispositif de commande asservit simultanément plus de deux éléments de positionnement (5) de telle sorte que, lors d'un positionnement, toutes les combinaisons souhaitées de circuits de courant de test entre les doigts de contact associés (10) sont formées et évaluées, de préférence en réduisant le nombre d'étapes de test sur la base de l'établissement de résultats de test combinatoires.

13. Dispositif de mise en contact selon une des revendications précédentes, **caractérisé** en ce que le champ de test (2) est divisé en zones virtuelles (22, 23, 24), au moins une paire de sondes (12) étant associée à chaque zone (22, 23, 24).

14. Dispositif de mise en contact selon la revendication 13, **caractérisé** en ce que les zones (22, 23, 24) du champ de test (2) sont de tailles différentes.

15. Dispositif de mise en contact selon une des revendications 13 ou 14, **caractérisé** en ce que la taille des zones (22, 23, 24) est choisie inversement proportionnelle au nombre des points de contact de la zone respective (22, 23, 24) qui doivent être mis en contact.

16. Dispositif de mise en contact selon une des revendications 13 à 15, **caractérisé** en ce que les zones (22, 23, 24) sont réalisées sous la forme de bandes (24) s'étendant sur la largeur ou, selon le cas, la longueur du champ de test (2).

17. Dispositif de mise en contact selon la revendication 16, **caractérisé** en ce que la largeur d'une bande (24) est choisie inférieure au rayon d'action du doigt de contact (10) disposé sur le bras pivotant associé (20).

18. Dispositif de mise en contact selon une des revendications 13 à 17, **caractérisé** en ce que les limites des zones (22, 23, 24) se situent sur des coordonnées X ou, selon le cas, Y constantes.

19. Dispositif de mise en contact selon une des revendications 13 à 18, **caractérisé** en ce que des zones voisines (22, 23, 24) se chevauchent par leurs régions bordantes.
